(19) Europäisches Patentamt
European Patent Office
Office européen des brevets

(11) **EP 0 896 429 B1**

(12) **EUROPÄISCHE PATENTSCHRIFT**

(45) Veröffentlichungstag und Bekanntmachung des Hinweises auf die Patenterteilung:
**10.08.2005 Patentblatt 2005/32**

(51) Int Cl.$^7$: **H03J 7/04**

(21) Anmeldenummer: **98109934.4**

(22) Anmeldetag: **30.05.1998**

(54) **Verfahren zur Messung und Korrektur der Frequenz eines Empfängeroszillators**

Method for measuring and correcting the frequency of a local oscillator

Méthode de mesure et de correction de la fréquence d' un oscillateur local

(84) Benannte Vertragsstaaten:
**AT BE CH CY DE DK ES FI FR GB GR IE IT LI LU MC NL PT SE**

(30) Priorität: **07.08.1997 DE 19734197**

(43) Veröffentlichungstag der Anmeldung:
**10.02.1999 Patentblatt 1999/06**

(73) Patentinhaber: **Deutsche Telekom AG**
**53113 Bonn (DE)**

(72) Erfinder:
- **Rudolph, Dietmar, Prof. Dr.-Ing.**
  **14163 Berlin (DE)**
- **Schäfer, Andreas**
  **15910 Freiwalde (DE)**
- **Hörlle, Christian**
  **10717 Berlin (DE)**

(56) Entgegenhaltungen:
**EP-A- 0 656 706**      **US-A- 4 227 252**
**US-A- 4 599 732**      **US-A- 5 343 497**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft ein Verfahren zur Messung und Korrektur der Frequenz von Empfängeroszillatoren, wobei zu übertragende Daten einem Trägersignal hochstufig aufmoduliert sind.

Stand der Technik

Verfahren der gattungsgemäßen Art sind bekannt. So werden beispielsweise bei der digitalen Runkfunkübertragung zu übertragende Daten (Informationen) als Nutzsignale hochstufig einem Trägersignal aufmoduliert. Hierzu werden beispielsweise eine 32-APSK-(Amplitude Phase shift keying) oder eine 64-APSK-Modulation verwendet. Derart modulierte Signale werden von einem Sender ausgesendet und von Empfängern empfangen. Im Sender werden zur Modulation Sendeoszillatoren und im Empfänger zur Demodulation Empfängeroszillatoren eingesetzt. Hierbei kann es durch Toleranzen der in den Oszillatoren eingesetzten Quarze zu einer Differenz zwischen einer Sollfrequenz am Senderoszillator und einer Istfrequenz am Empfängeroszillator kommen, die eine Synchronität zwischen Sender und Empfänger beeinträchtigen. Insbesondere dadurch, daß aufgrund des massenhaften Einsatzes von Empfängern die dort verwendeten Quarze preisgünstig sein müssen, weisen diese eine relativ hohe Toleranz und somit Ungenauigkeit auf. Eine Frequenzdifferenz zwischen der Sollfrequenz und der Istfrequenz bewirkt eine Drehung des Phasensternes im Empfänger, da die Frequenzlage des empfangenen Signales nicht mehr genau stimmt. Bei einer maximal möglichen Toleranz der Oszillatorfrequenz im Senderoszillator, die üblicherweise im Bereich von $10^{-6}$ liegt, sind beispielsweise bei einer Sendung im oberen Kurzwellenbereich bei 30 MHz Toleranzen von $\pm$ 30 Hz möglich. Durch den Einsatz preisgünstigerer Quarze in den Empfängeroszillatoren, weisen diese üblicherweise eine Toleranz von $10^{-4}$ auf, was bei dem genannten Beispiel zu Frequenzabweichungen von bis zu $\pm$ 3 kHz führen kann.

Aus "Synchronization in Digital Communications Volum 1", H. Meyr, G. Ascheid, Verlag John Wiley & Sons, 1989 ist ein Verfahren bekannt, bei dem eine Frequenzdifferenz zwischen einer Sollfrequenz und der Istfrequenz geschätzt wird. Hierbei wird davon ausgegangen, daß man auf Empfängerseite von dem empfangenen Signal annimmt, daß es rauschähnliche Eigenschaften haben muß. Es wird anhand der mittleren Phasenänderung des empfangenen digitalen Signales die Frequenzdifferenz geschätzt. Hierbei ist nachteilig, daß eine Frequenzdifferenz nur mit einem relativ großen Fehler ermittelbar ist. Das Dokument US-A-5 343 497 veröffentlicht einer solches Verfahren.

Der Erfindung liegt die Aufgabe zugrunde, ein Verfahren der gattungsgemäßen Art anzugeben, mittels dem eine Störung der empfangenen Daten infolge einer Toleranz der eingesetzten Quarze in den Sender- und Empfängeroszillatoren verringert werden kann.

Erfindungsgemäß wird diese Aufgabe mit einem Verfahren mit den im Anspruch 1 genannten Merkmalen gelöst. Dadurch, daß die Daten als Nutzsignale alternierend mit niederstufig aufmodulierten Testsignalen übertragen werden, und beim Empfang der digitalen Signale eine Frequenzdifferenz zwischen einer Sollfrequenz eines Senderoszillators und einer Istfrequenz eines Empfängeroszillators gemessen wird, und aus dieser Frequenzdifferenz ein Regelsignal zur Einstellung des Empfängeroszillators auf die Sollfrequenz ermittelt wird, ist es vorteilhaft möglich, eine sich für den jeweiligen Empfänger ergebende Frequenzdifferenz zu ermitteln und diese empfängerbezogen bei der Auswertung der Nutzsignale zu berücksichtigen.

In bevorzugter Ausgestaltung der Erfindung ist vorgesehen, das Verfahren mehrstufig durchzuführen, wobei entsprechend einer tatsächlich auftretenden Frequenzdifferenz zwischen der Sollfrequenz und der Istfrequenz die einzelnen Stufen des Verfahrens nacheinander abgearbeitet werden, so daß die Genauigkeit der Regelung des Empfängeroszillators stufenweise zunimmt. Hierdurch kann in einfacher Weise eine Aufteilung der Ermittlung der Frequenzdifferenz in einzelne Schritte erfolgen, wobei innerhalb der einzelnen Schritte jeweils auf diese Schritte abgestimmte Frequenzmeßverfahren einsetzbar sind, die jeweils einzeln optimierbar sind. Hierdurch kann sehr vorteilhaft, beispielsweise in einer ersten Stufe, mittels eines relativ groben Meßverfahrens eine Voreinstellung erfolgen, während die Feineinstellung mittels eines für den dann nur noch vorhandenen kleineren Frequenzdifferenzbereich ausgelegten Meßverfahrens erfolgen kann. Insgesamt ergibt sich somit ein hochgenaues Verfahren, bei dem Toleranzen zwischen den Quarzen der Senderoszillatoren und der Empfängeroszillatoren sicher erkannt und empfängerbezogen, das heißt, für jeden Empfänger angepaßt, ausgeglichen werden können.

Weitere vorteilhafte Ausgestaltungen der Erfindung ergeben sich aus den übrigen, in den Unteransprüchen genannten Merkmalen.

Zeichnungen

Die Erfindung wird nachfolgend in einem Ausführungsbeispiel anhand der zugehörigen Zeichnungen näher erläutert. Es zeigen:

Figur 1     eine schematische Struktur eines übertragenen digitalen Signales;

Figur 2     ein Blockschaltbild zur Ermittlung einer Frequenzdifferenz und

Figur 3     ein Blockschaltbild zum Abgleich eines Empfängeroszillators.

Beschreibung des Ausführungsbeispiel

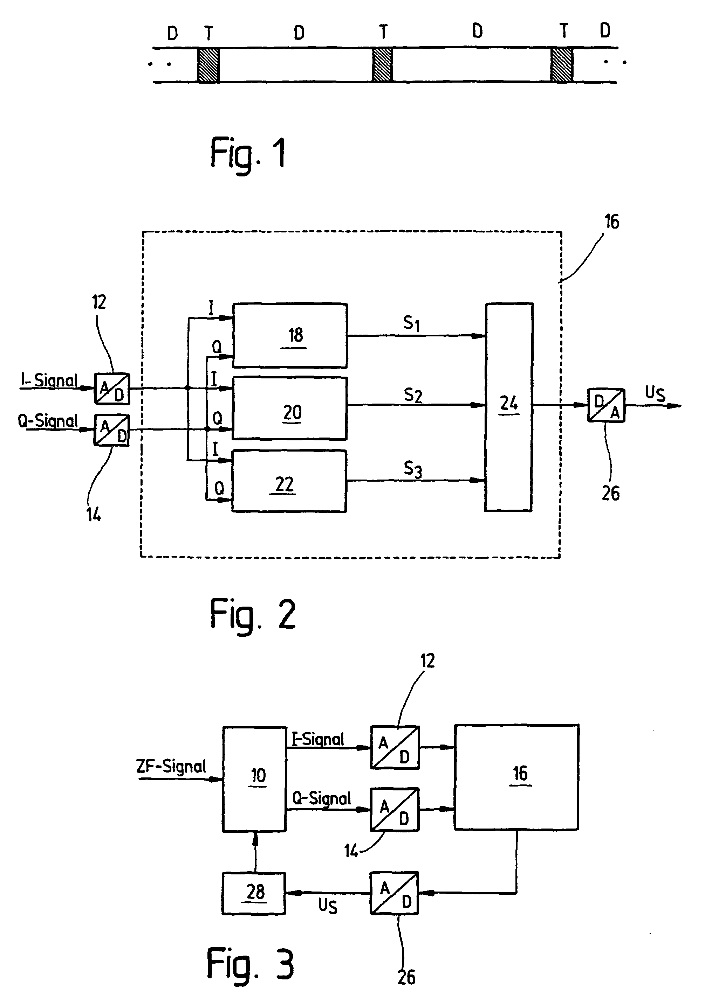

In der Figur 1 ist die Struktur eines übertragenen digitalen Signales schematisch angedeutet. Es wird deutlich, daß der Datenstrom des übertragenen digitalen Signales unterschiedliche, sich abwechselnde Sequenzen aufweist. Es ist vorgesehen, daß die zu übertragenden Daten als Nutzsignale D alternierend mit Testsignalen T übertragen werden. Die Nutzsignale D sind hochstufig digital moduliert, beispielsweise mittels einer 32-APSK- oder einer 64-APSK-Modulation. Die Testsignale T sind niederstufig, beispielsweise mit einer 2-PSK-Modulation moduliert und bestehen aus einer bekannten Folge binärer Testsignale, die beispielsweise in einer Sendeeinrichtung mit einer Pseudo-Random-Folge erzeugt werden. Hinsichtlich der Struktur der Übertragung der digitalen Signale wird auf die ältere Patentanmeldung DE 196 46 164 verwiesen, deren Inhalt hiermit ausdrücklich in die Offenbarung dieser Beschreibung aufgenommen wird.

Anhand der übertragenen Testsignale T wird entsprechend des nachfolgend erläuterten Verfahrens eine Frequenzdifferenz zwischen einer Sollfrequenz eines Quarzes eines Senderoszillators und einer Istfrequenz eines Quarzes eines Empfängeroszillators ermittelt. Das empfangene digitale Signal (ZF-Signal) wird mittels eines I/Q-Mischers 10 in einen I-Signalanteil und einen Q-Signalanteil zerlegt. Über Analog-Digital-Wandler 12 und 14 wird das I-Signal und das Q-Signal einem digitalen Signalprozessor 16 zugeführt. Sowohl das I-Signal als auch das Q-Signal werden drei Auswertestufen 18, 20, beziehungsweise 22 zugeführt. Die Signale werden hierbei in den Auswertestufen 18, 20 und 22 nacheinander ausgewertet, das heißt, die Auswertestufen 18, 20 und 22 bauen aufeinander auf. Zunächst erfolgt eine Auswertung mit der Auswertestufe 18, dann mit der Auswertestufe 20 und schließlich mit der Auswertestufe 22.

Im einzelnen wird die Auswertung folgendermaßen durchgeführt:

Zunächst wird in der Auswertestufe 18 eine mittlere Phasendifferenz zwischen aufeinanderfolgenden Abtastwerten des empfangenen Signales ermittelt. Diese mittlere Phasendifferenz ist proportional einer Frequenzabweichung zwischen einer Sollfrequenz eines Senderoszillators und einer Istfrequenz eines Empfängeroszillators. Hierbei wird über ein Schätzverfahren, beispielsweise dem sogenannten Maximum Likelihood-Verfahren, die mittlere Phasenänderung der empfangenen Signale ausgewertet. Durch die Auswertestufe 18 erfolgt eine relativ grobe Frequenzdifferenz-Ermittlung, wobei ein entsprechend der ermittelten Frequenzdifferenz generiertes Steuersignal $S_1$ einem Summierglied 24 zugeführt wird. Der Ausgang des Summiergliedes 24 ist mit einem Digital/Analogwandler 26 verbunden, an dessen Ausgang eine Regelspannung $U_S$ anliegt. Diese Regelspannung $U_S$ wird dem Oszillator 28 des Empfängers als Korrektursignal zugeführt, wobei der Oszillator 28 auf den I/Q-Mischer 10 zurückwirkt und eine empfängerseitige Frequenzkorrektur des empfangenen ZF-Signales durchführt.

Die bis hier erläuterte Frequenzkorrektur, zum Abgleich einer Frequenzdifferenz zwischen einer Sollfrequenz und einer Istfrequenz basiert auf dem in der Auswertestufe 18 gewonnenen Steuersignal $S_1$. Dieses ist mit einer relativ hohen Ungenauigkeit behaftet. Jedoch wird hierdurch erreicht, daß durch die Auswertestufe 18 ein relativ großer Frequenzbereich abgedeckt werden kann, und die Istfrequenz relativ nah an die Sollfrequenz herangeführt werden kann. Somit kann das bereits korrigierte (vorkorrigierte) I-Signal und Q-Signal einer genaueren Auswertung in der Auswertestufe 20 unterzogen werden. Um eine Meßgenauigkeit der Auswertestufe 18 zu erhöhen, ist vorgesehen, daß die Abtastwerte des empfangenen digitalen Signales unter einer bestimmten Mindestgröße, die beispielsweise 20 % eines Maximalwertes beträgt, nicht verwendet werden.

In der Auswertestufe 20 erfolgt nunmehr eine exakte Differenzfrequenzmessung der Istfrequenz des Empfängeroszillators (gegenüber einer Frequenzschätzung in der Auswertestufe 18). Die Auswertestufe 20 beginnt die Testsignale T auszuwerten, wenn eine für die Auswertestufe 20 festgelegte maximal zulässige Frequenzabweichung $f_{diff(max)}$ von der tatsächlichen Differenzfrequenz unterschritten wird. Ist diese Differenzfrequenz größer als die maximal zulässige Differenzfrequenz, wird die Auswertestufe 18 nochmals durchlaufen. Eine Erkennung der maximal zulässigen Differenzfrequenz hängt von einer Korrelationslänge $k_{korr}$ und einer Symbolrate ab und liegt beispielsweise bei einer Korrelation über 19 Symbole und einer Übertragungsgeschwindigkeit von 7200 Symbolen pro Sekunden innerhalb der Testsignale T bei circa gemessenen 150 Hz (rein rechnerisch bei circa 190 Hz). Hierbei gilt die Beziehung:

$$f_{diff(max)} = \frac{1}{(2 * T_{Sym} * k_{korr})},$$

wobei $T_{Sym}$ der Dauer eines Symboles entspricht.

Ist die Position der Testsequenz T erkannt, kann aus der bekannten Struktur der Testsequenz T eine exakte Frequenzdifferenz zwischen der Sollfrequenz und der Istfrequenz gemessen werden. Eine Phasendrehung infolge einer Frequenzdifferenz läßt sich aus der Testsequenz erkennen. Wird diese als 2-PSK-Modulation übertragen sind lediglich zwei Phasenzustände möglich, die sich um 180° voneinander unterscheiden. Werden aufeinanderfolgende Abtastwerte der Testsequenz ausgewertet, kann die Phasendifferenz von einem Abtastwert zum nächsten Abtastwert entweder 0° oder 180° betragen. Liegt eine zusätzliche Phasendrehung φ durch eine Differenzfrequenz vor, entspricht die Phasendifferenz zwischen den zwei Abtastwerten entweder der Phasendrehung φ oder 180° + φ.

Geht man weiterhin davon aus, daß bei einer Phasen-differenz φ von mehr als 90° zwischen zwei aufeinanderfolgenden Abtastwerten das gegenüberliegende Symbol der 2-PSK-Modulation empfangen wurde, können in diesem Fall von der Phasendifferenz 180° subtrahiert werden. Das Ergebnis ist in jedem Fall die Phasendrehung φ, die durch die Frequenzdifferenz zwischen der Solldifferenz und der Istdifferenz verursacht wird. Somit können Phasendrehungen bis zu 90° zwischen zwei aufeinanderfolgenden Abtastwerten ermittelt werden. Entsprechend der in der Auswertestufe 20 ermittelten Phasendrehung φ wird ein Steuersignal $S_2$ bereitgestellt, das dem Summierer 24 zugeführt wird. Der Summierer 24 liefert darauf ein dem Steuersignal $S_2$ entsprechendes Signal an den Digital/Analogwandler 26, so daß eine entsprechend gewandelte Signalspannung $U_S$ dem Oszillator 28 zugeführt wird. Dieser kann durch diese Korrekturspannung die Empfängeroszillatorfrequenz somit exakt auf die Sollfrequenz einstellen. Aufgrund des linearen Zusammenhanges zwischen der Phasendrehung φ und der Frequenzdifferenz kann diese mit sehr hoher Genauigkeit ermittelt werden. Die Sollfrequenz des Empfängeroszillators 28 wird somit mit hoher Genauigkeit der Istfrequenz des Senderoszillators entsprechen.

Um die Genauigkeit des Verfahrens zu erhöhen, kann vorgesehen sein, Abtastwerte innerhalb der Testsequenz T mit einer sehr geringen Amplitude nicht auszuwerten. Diese können beispielsweise vom Nulldurchgang beim Wechsel zwischen zwei Symbolen stammen. Da diese Wechsel in der Regel nicht exakt durch den Nullpunkt gehen, sind hier beliebige Phasenlagen möglich. Um einen hieraus resultierenden Fehler auszuschließen, kann beispielsweise eine Grenze von 20 % des mittleren Betrages der Abtastwerte, die zur Auswertung überschritten werden muß, festgelegt werden. Abtastwerte mit einem kleineren Betrag werden demnach nicht berücksichtigt. Hierbei wird die Phasendrehung φ über mehrere Abtastwerte ermittelt. Die Phasendre-Phasendrehung φ darf auch hier maximal 90° betragen, um ein eindeutiges Ergebnis der Frequenzmessung in der Auswertestufe 20 zu erhalten.

Nachdem durch das beschriebene stufenweise Angleichen der Sollfrequenz an die Istfrequenz eine Differenzfrequenz zwischen der Sollfrequenz und der Istfrequenz eliminiert ist, beginnt der Empfang der Nutzsignale D. Da eine Frequenzdifferenz zwischen der Sollfrequenz und der Istfrequenz bereits ausgeglichen ist, kann der Empfang der Nutzsignale D mittels eines verhältnismäßig einfachen Frequenzregelverfahren innerhalb der Auswertestufe 22 erfolgen.

Hierzu wird eine Kanalentzerrung durchgeführt, um aus den empfangenen Testsignalen T eine Kanalimpulsantwort zu erhalten. Mit Hilfe der Kanalimpulsantwort kann eine, infolge eines innerhalb des Übertragungskanales auftretenden Echos sich einstellende Frequenzschwankung ermittelt werden. Anhand der berechneten Kanalimpulsantwort der Testsignale T können die gesendeten Nutzsignale D exakt rekonstruiert werden.

Die Frequenzschwankung wird fortlaufend während der Übertragung der Nutzsignale D gemessen. Hierzu wird jeweils nur die Phasenlage des Maximums der Kanalimpulsantwort ermittelt und die Istfrequenz des Oszillators 28, durch Bereitstellung eines Steuersignales $S_3$, das in die Regelspannung $U_S$ übergeht, entsprechend nachgestellt. Somit kann die Istfrequenz des Oszillators 28 mit sehr hoher Genauigkeit auf die Sollfrequenz des Senderoszillators eingestellt werden.

Es kann vorgesehen sein, mittels der Auswertestufe 22 eine geringfügige Frequenzdifferenz zwischen der Istfrequenz und der Sollfrequenz zuzulassen, da andernfalls aufgrund der sich fortlaufend ändernden Kanalimpulsantwort eine ständige Nachstellung der Frequenz des Oszillators 28 erfolgen würde. Hierdurch könnte eine Beeinträchtigung der Demodulation der übertragenden digitalen Signale erfolgen.

Somit kann nach Durchlaufen der Auswertestufen 18 und 20 mittels der Auswertestufe 22 mit relativ geringem Rechenaufwand eine Eliminierung einer Frequenzdifferenz beziehungsweise eine Einstelllung einer maximal zulässigen, minimalen Frequenzdifferenz erfolgen. Durch die Mehrstufigkeit des Verfahrens wird jede Auswertestufe 18, 20, 22 nur solange verwendet, bis die nächstbessere (Auswertestufe 20) oder die nächste weniger aufwendige Auswertestufe (Auswertestufe 22) arbeiten kann.

Durch eine Kombination mehrerer Methoden, einerseits einer Frequenzdifferenzschätzung und andererseits einer auf der Schätzung aufbauenden Frequenzdifferenzmessung, kann mit hoher Sicherheit ein Frequenzfehler ermittelt und ausgeregelt werden. Hierdurch wird eine Genauigkeit des Differenzfrequenzausgleiches gegenüber den bekannten Verfahren wesentlich erhöht. Schließlich kann mittels der Auswertestufe 22 eine fortlaufende Frequenzsynchronität zwischen der Sollfrequenz und der Istfrequenz während der Übertragung der Nutzsignale D sichergestellt werden.

**Patentansprüche**

**1.** Verfahren zur Messung und Korrektur der Frequenz von Empfängeroszillatoren, wobei zu übertragende digitale Daten einem Trägersignal hochstufig aufmoduliert sind, die Daten als Nutzsignale (D) alternierend mit niederstufig aufmodulierten Testsignalen (T) übertragen werden, beim Empfang der digitalen Signale eine Frequenzdifferenz zwischen einer Sollfrequenz eines Senderoszillators und einer Istfrequenz eines Empfängeroszillators (28) anhand der Testsignale (T) ermittelt wird und aus dieser Frequenzdifferenz ein Regelsignal ($U_S$) zur Einstellung des Empfängeroszillators (28) auf die Sollfrequenz ermittelt wird, **dadurch gekennzeichnet, dass** die Frequenzdifferenz mehrstufig ausgeglichen wird, wobei die einzelnen Stufen (18,20,22) aufeinander aufbauen.

2. Verfahren nach einem der vorhergehenden Ansprüche, **dadurch gekennzeichnet, daß** die digitalen Signale in einem dreistufigen Verfahren ausgewertet werden.

3. Verfahren nach einem der vorhergehenden Ansprüche, **dadurch gekennzeichnet, daß** in einer ersten Auswertestufe (18) eine mittlere Phasendifferenz zwischen aufeinanderfolgenden Abtastwerten des empfangenen Signales ermittelt wird, wobei ein der Phasendifferenz entsprechendes Steuersignal ($S_1$) eine Regelspannung ($U_S$) für den Empfängeroszillator (28) liefert.

4. Verfahren nach einem der vorhergehenden Ansprüche, **dadurch gekennzeichnet, daß** in einer zweiten Auswertestufe (20) eine Differenzfrequenzmessung erfolgt, die dann einsetzt, wenn eine über die Auswertestufe (18) eingestellte Differenzfrequenz geringer ist als eine für die zweite Auswertestufe (20) festgelegte maximal zulässige Frequenzdifferenz ($f_{diff(max)}$)

5. Verfahren nach einem der vorhergehenden Ansprüche, **dadurch gekennzeichnet, daß** über die zweite Auswertestufe (20) ein der Differenzfrequenz entsprechendes Steuersignal ($S_2$) die Regelspannung ($U_S$) für den Empfängeroszillator (28) liefert.

6. Verfahren nach einem der vorhergehenden Ansprüche, **dadurch gekennzeichnet, daß** durch die Auswertestufe (20) Abtastwerte mit geringer Amplitude, insbesondere die, die eine Grenze von 20 % eines mittleren Betrages der Abtastwerte unterschreiten, nicht ausgewertet werden.

7. Verfahren nach einem der vorhergehenden Ansprüche, **dadurch gekennzeichnet, daß** die Auswertestufe (22) eine vorgebbare geringfügige Differenzfrequenz zuläßt.

8. Verfahren nach einem der vorhergehenden Ansprüche, **dadurch gekennzeichnet, daß** eine dritte Auswertestufe (22) mittels einer Kanalentzerrung eine Kanalimpulsantwort erfaßt, wobei ein der Kanalimpulsantwort entsprechendes Steuersignal ($S_3$) die Regelspannung ($U_S$) für den Empfängeroszillator (28) liefert.

**Claims**

1. Method for measurement and correction of the frequency of receiver oscillators, wherein digital data to be transmitted are modulated onto a carrier signal at a high level, the data are transmitted as information signals (D) alternating with test signals (T) modulated at a low level, on reception of the digital signals a frequency difference between a nominal frequency of a transmitter oscillator and an actual frequency of a receiver oscillator (28) is determined on the basis of the test signal (T), and from this frequency difference is derived a control signal ($U_S$) for adjusting the receiver oscillator (28) to the nominal frequency, **characterized in that** the frequency difference is compensated in multiple stages, the individual stages (18, 20, 22) building on one another.

2. Method according to one of the preceding claims, **characterized in that** the digital signals are evaluated in a three-stage process.

3. Method according to one of the preceding claims, **characterized in that**, in a first analysis stage (18), an average phase difference between sequential sampled values of the received signal is determined, with a control signal ($S_1$) corresponding to the phase difference providing a control voltage ($U_S$) for the receiver oscillator (28).

4. Method according to one of the preceding claims, **characterized in that,** in a second analysis stage (20), a difference frequency measurement occurs that starts when a difference frequency adjusted through the analysis stage (18) is less than a maximum permissible frequency difference ($f_{diff(max)}$) specified for the second analysis stage (20).

5. Method according to one of the preceding claims, **characterized in that** a control signal ($S_2$) corresponding to the difference frequency provides the control voltage ($U_S$) for the receiver oscillator (28) by means of the second analysis stage (20).

6. Method according to one of the preceding claims, **characterized in that** sampled values with low amplitude, in particular those falling below a threshold of 20% of an average value of the sampled values, are not analyzed by the analysis stage (20).

7. Method according to one of the preceding claims, **characterized in that** the analysis stage (22) permits a specifiable, small difference frequency.

8. Method according to one of the preceding claims, **characterized in that** a third analysis stage (22) measures a channel impulse response by means of a channel equalization, with a control signal ($S_3$) corresponding to the channel impulse response providing the control voltage ($U_S$) for the receiver oscillator (28).

## Revendications

1. Procédé destiné à la mesure et la correction de la fréquence d'oscillateurs de réception, les données numériques à transmettre étant hautement modulés sur un signal porteur, les données étant transmises en tant que signaux utiles (D) en alternance avec des signaux d'essai (T) bassement modulés, une différence de fréquence entre une fréquence nominale d'un oscillateur d'émission et la fréquence effective d'un oscillateur de réception (28) étant déterminée grâce aux signaux d'essai (T) lors de la réception des signaux numériques, et un signal régulateur ($U_S$) étant déterminé à partir de cette différence de fréquence pour le réglage de l'oscillateur de réception (28) à la fréquence nominale, **caractérisé en ce que** la différence de fréquence est équilibrée à plusieurs étages, les différents étages (18, 20, 22) étant basés les uns sur les autres.

2. Procédé selon la revendication 1, **caractérisé en ce que** les signaux numériques sont évalués dans un procédé à trois étages.

3. Procédé selon l'une des revendications précédentes, **caractérisé en ce que** dans un premier étage d'évaluation (18) une différence de phase moyenne entre des échantillons successifs du signal reçu est déterminée, un signal de commande ($S_1$) correspondant à la différence de phase fournissant une tension de régulation ($U_S$) pour l'oscillateur de réception (28).

4. Procédé selon l'une des revendications précédentes, **caractérisé en ce que** dans un deuxième étage d'évaluation (20) une mesure de la différence de fréquence a lieu, commençant lorsqu'une fréquence de différence réglée par l'étage d'évaluation (18) est inférieure à une différence de fréquence maximale admissible ($f_{diff\,(max)}$) fixée pour le deuxième étage d'évaluation (20).

5. Procédé selon l'une des revendications précédentes, **caractérisé en ce qu'**un signal de commande ($S_2$), correspondant à la fréquence de différence, fournit la tension de régulation ($U_S$) pour l'oscillateur de réception (28) par le deuxième étage d'évaluation (20).

6. Procédé selon l'une des revendications précédentes, **caractérisé en ce que** des échantillons à basse amplitude, notamment ceux qui restent inférieurs à une limite de 20% d'un montant d'échantillons moyen, ne sont pas évalués par l'étage d'évaluation (20).

7. Procédé selon l'une des revendications précédentes, **caractérisé en ce que** l'étage d'évaluation (22) admet une petite différence de fréquence pouvant être prédéfinie.

8. Procédé selon l'une des revendications précédentes, **caractérisé en ce qu'**un troisième étage d'évaluation (22) détecte une réponse en impulsion du canal grâce à une égalisation de canal, un signal de commande ($S_3$) correspondant à la réponse en impulsion du canal fournissant la tension de régulation ($U_S$) pour l'oscillateur de réception (28).

D   T      D      T       D      T   D

Fig. 1

Fig. 2

Fig. 3